Europäisches Patentamt

European Patent Office

Office européen des brevets

(11) Publication number: **0 203 700**
**A2**

## EUROPEAN PATENT APPLICATION

(21) Application number: 86302923.7

(22) Date of filing: 18.04.86

(51) Int. Cl.⁴: **H 03 K 19/092**, H 03 K 19/013

(30) Priority: 19.04.85 US 725025

(43) Date of publication of application: 03.12.86
Bulletin 86/49

(84) Designated Contracting States: **AT BE CH DE FR GB IT LI
LU NL SE**

(71) Applicant: **ADVANCED MICRO DEVICES, INC.,
901 Thompson Place P.O. Box 3453, Sunnyvale,
CA 94088 (US)**

(72) Inventor: **Williams, Bertrand Jeffery, 1800 Stevens
Canyon No. 4, California 95014 (US)**
Inventor: **Wilson, Stanley, 1386 Colinton Way, Sunnyvale
California (US)**

(74) Representative: **Sanders, Peter Colin Christopher et al,
BROOKES & MARTIN High Holborn House 52/54 High
Holborn, London WC1V 6SE (GB)**

(54) **Logic level translators.**

(57) A logic level translator having high switching speeds for
converting ECL logic levels into TTL logic levels includes a pair
of input transistors for receiving ECL input logic level signals
and an output transistor for generating TTL output logic level
signals. Current mirror transistors are interconnected between
the input transistors and the output transistor for turning on
and off the output transistor. High-pass networks are coupled
to the current mirror transistors for increasing its transient
response so as to facilitate turning on and off quickly the output
transistor. The TTL output logic levels have a relatively small
propagation delay responsive to transitions of the ECL input
logic level signals.

## LOGIC LEVEL TRANSLATORS

Computer data processing systems may use various types of logic in different parts of the processing system. In order to transfer data from one part of the processing system to another part, there is often required a translation from one type of logic to another type of logic. Since many of these processing systems are designed with both ECL and TTL logic circuits, there has been encountered a need for interface circuits such as ECL-to-TTL and TTL-to-ECL translators so that these types of logic circuits will be compatible with each other.

As is generally known in the art, TTL logic circuits typically operate on logic signal levels below 0.3 volts and above 3.5 volts and ECL logic circuits typically operate on different logic signal levels. While the precise levels utilised in the ECL logic circuits differ among manufacturers, the voltage swing between the two ECL logic levels is commonly less than the voltage swing between the two TTL logic levels. Thus, in order to shift or convert ECL logic level signals to TTL logic level signals it can be seen that the smaller ECL input swing must result in a larger TTL output swing. One of the major problems experienced is that these level translator circuits tend to cause too large a propagation delay in transmitting data from the input to the output. In other words, the response time is relatively slow during switching between the low and high output logic levels.

Accordingly, it is a general object of the present invention to provide an improved logic level translator for converting ECL logic levels into TTL logic levels, particularly one having an improved switching speed or response time.

According to one aspect of the present invention a logic level translator having high switching speeds includes current mirror transistors, an inverter transistor, and high-pass networks coupled to the current mirror transistors to produce a quick switching of the inverter transistor.

According to another aspect of the present invention a logic level translator includes transient circuit networks for increasing the transient response of current mirror transistors so as to facilitate turning off and on quickly an output transistor.

According to one embodiment of the invention, there is provided a logic level translator having high switching speeds for converting ECL logic levels into TTL logic levels, the translator including a pair of first and second input transistors having their collectors connected to a supply potential. The bases of the first and second transistors are adapted to receive ECL input logic level signals. A third transistor has its base and collector connected together and to the emitter of the first transistor. A fourth transistor has its base and collector connected together and to the emitter of the second transistor. A current mirror is formed of a pair of fifth and sixth transistors having their emitters connected together and to a ground potential.    A first resistor and a first capacitor are connected in parallel with its one end connected to the emitter of the third transistor and its other end connected to the collector of the fifth transistor.    A second resistor and a second capacitor are connected in parallel with its one end connected to the emitter of the fourth transistor and its other end connected to the collector of the sixth transistor.    An inverter transistor has its base connected to the collector of the sixth transistor, its collector connected to the supply potential via a load resistor and its emitter connected to the ground potential.

High-pass networks are used to generate large transient drive current differences at the base of the fifth and sixth transistors so as to facilitate turning on quickly one of them and turning off quickly the other one of them.    The base of the inverter transistor is responsive to the drive current differences at the bases of the fifth and sixth transistors so as to create a very fast output response at TTL logic levels on its collector during transitions of the ECL input logic levels.

In one alternative embodiment, the third and fourth transistors are eliminated from the logic level translator.    Thus, the first resistor and first capacitor have their one end connected to the emitter of the first transistor.    Similarly, the second resistor and second capacitor have their one end connected to the emitter of the second transistor.

-4-

In the accompanying drawings, by way of example only:-

Figure 1 is a detailed schematic circuit diagram of a ECL-to-TTL logic level translator of the prior art which is interfaced between an ECL input stage and a TTL output stage;

Figure 2 is a detailed schematic circuit diagram of a logic level translator embodying the present invention; and

Figure 3(a) - 3(c) are waveforms useful in understanding the operation of the logic level translator of Figure 2.

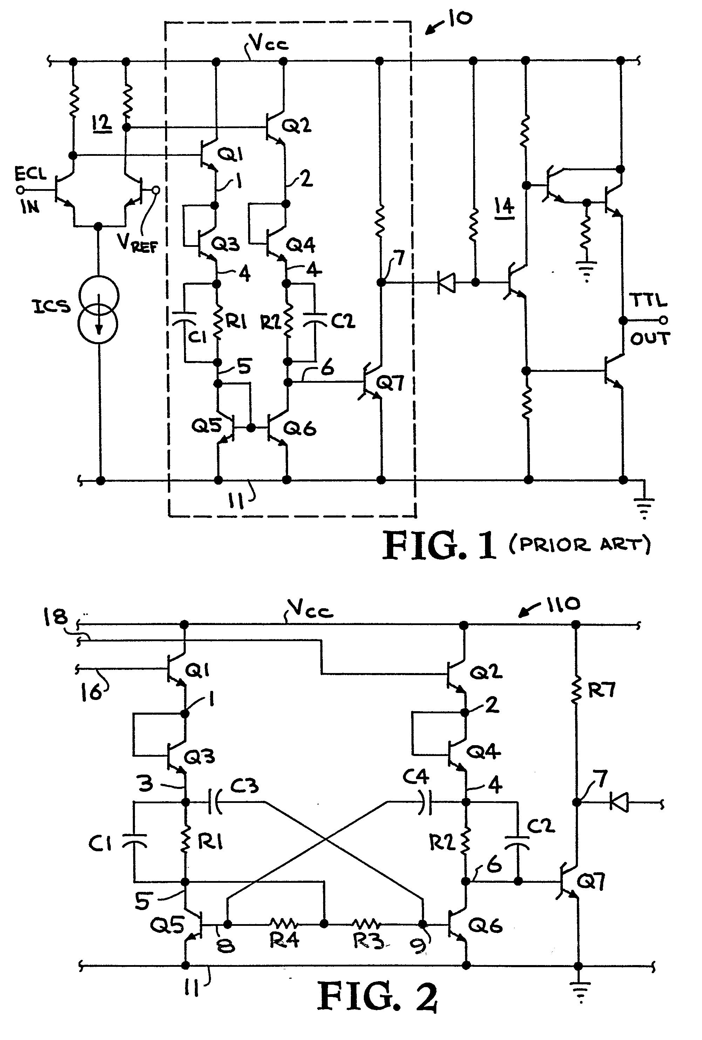

A logic level translator of the prior art is shown in Figure 1.  The prior art translator 10 is interconnected between an ECL input stage 12 and a TTL output stage 14.  A logic level translator embodying the present invention is shown in Fig. 2. This is an improvement over the translator circuit of Figure 1 and exhibits a faster response time. The propagation delay during the low-to-high output transition or high-to-low output transition of the level translator of Figure 2 is reduced by approximately 2 nanoseconds over the translator circuit of Figure 1.

In Figure 1 the prior art logic level translator 10 is interconnected between an ECL input stage 12 and a TTL output stage 14.  The input of the translator 10 is connected to the output of the ECL input stage 12.  The output of the translator 10 is connected to the input of the TTL output stage 14.

0203700

In Figure 2, the logic level translator 110 includes
a

pair of input transistors Q1 and Q2 having their collectors connected to a TTL power supply voltage VCC which is preferably +5.0 volts. As can be seen, the transistors Q1, Q2 are bipolar transistors of the NPN-type. The bases of the input transistors Q1 and Q2 are connectable to the outputs of the ECL input stage 12 (Fig.1) for receiving ECL logic level signals via lead lines 16 and 18, respectively. In this logic translator 110, it is assumed that the ECL input levels swing between the ECL power supply voltage which is also VCC or +5 volts and VCC less 750mv. Accordingly, the difference in voltage levels on the lead lines 16 and 18 will be approximately 750mv. When the base of the transistor Q1 receives the higher voltage level or VCC representing the logic level "1," the transistor Q1 will be rendered more conductive and the transistor Q2 will be rendered less conductive since its base will be receiving the lower voltage level or VCC less 750mv representing the logic level "0". On the other hand, when the base of the transistor Q2 receives the higher voltage level of VCC and the base of the transistor Q1 receives the lower voltage level of VCC less 750mv, the transistor Q2 will be rendered more conductive and the transistor Q1 will be rendered less conductive.

The emitter of the transistor Q1 is connected to the collector and base of a transistor Q3 which functions as a diode. A current-limiting resistor R1 has its one end connected to the emitter of the transistor Q3. An edge accelerator capacitor C1 is connected in parallel across the resistor R1. Similarly, the emitter of the transistor Q2 is connected to the collector and base of a transistor Q4 which functions as a diode. A current-limiting resistor R2 has its one end connected to the emitter of the transistor Q4. An edge accelerator capacitor C2 is connected in parallel across the resistor R2. It should be noted that the transistors Q3 and Q4 are bipolar transistors of the NPN-type. Further, the transistors Q3 and Q4 may be eliminated entirely as can be appreciated by those skilled in the art.

A current mirror arrangement is formed by a pair of transistors Q5 and Q6 whose emitters are connected together and to a TTL ground potential which is preferably 0 volts. The transistors Q5 and Q6 are formed of bipolar transistors of the NPN-type. The collector of the transistor Q5 is connected to the other end of the current-limiting resistor R1. The collector of the transistor Q6 is connected to the other end of the current-limiting resistor R2. An inverter or output transistor Q7 has its base also connected to the collector of the transistor Q6. The emitter of the transistor Q7 is tied to the TTL ground potential. The collector of the transistor Q7 is connected to the TTL supply voltage VCC via a load resistor R7. The output of the level translator 110 is at the junction of the collector of the transistor Q7 and the resistor R7. The transistor Q7 is preferably a Schottky transistor so as to prevent saturation and thus increases its switching speed.

In order to further increase the switching speed of the transistor Q7 so as to obtain a faster response at its collector, a pair of first and second high-pass networks are coupled into the current mirror transistors Q5 and Q6 so as to provide large transient drive current differences at the bases of the transistors Q5 and Q6. As a result, the transistor Q6 will be turned off and on quicker so as to exhibit a fast response time at node 6 during switching of logic levels. Consequently, the propagation delay during low-to-high and high-to-low output transitions will be significantly reduced at the output on node 7. It has been found that the propagation delay at node 7 of the present translator 110 during transition is reduced by approximately 2 nanoseconds over the translator circuit 10 of Figure 1.

The first high-pass network is formed of a resistor R3 and a capacitor C3. The second high-pass network is formed of a resistor R4 and a capacitor C4. One end of the resistor R4 is coupled to the base of the transistor Q5 and to one end of the capacitor C4. The other end of the resistor R4 is connected to one end of the resistor R3. The junction of the resistors R3 and R4 is joined to the collector of the transistor Q5. The other end of the resistor R3 is tied to one end of the capacitor C3. The other end of the capacitor C3 is joined to the emitter of the transistor Q3, and the other end of the capacitor C4 is tied to the emitter of the transistor Q4.

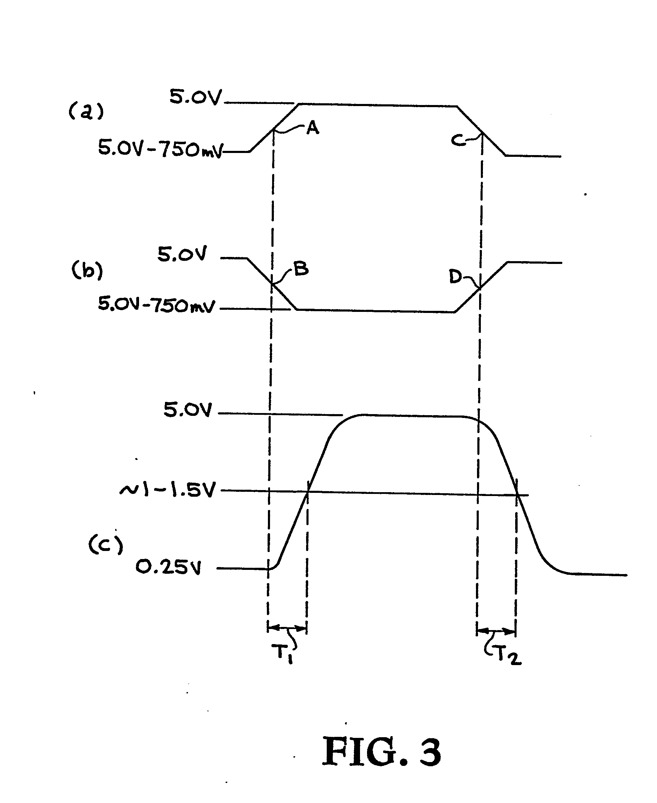

The operation of the translator 110 of the present invention shown in Figure 2 will be described in connection with the waveforms of Figure 3(a) - (c). During a low-to-high transition (curve A of Fig. 3a) the ECL logic signal at the base of the transistor Q1 is switched from 5 volts minus 750mv representing the logic level "0" to +5 volts representing the logic level "1". Simultaneously, a high-to-low transition (curve B of Fig. 3b) occurs at the base of the transistor Q2 where the ECL logic signal is switched from +5 volts representing the logic "1" to +5 volts minus 750mv representing the logic level "0". This causes the transistor Q1 to be rendered more conductive and the transistor Q2 will be rendered less conductive. Thus, the potential at the emitter of the transistor Q1 or node 1 will rise toward the +5.0 volts supply voltage so as to create a transient current passing through the diode-connected transistor Q3 and appearing at the node 3. Since capacitors act initially as a short circuit under transient conditions, a first base drive current will be supplied to turned on the transistor Q6 via the capacitor C1 and the resistor R3. However, in order to turn on the transistor Q6 faster, additional or second base drive current will be supplied to the base of the transistor Q6 via the capacitor C3. As a result, a larger current will appear at the base or node 9 for turning on quickly the transistor Q6. Once the transistor Q6 is rendered more conductive, base current will be pulled out of the transistor Q7 which will cause it to turn off quickly. Therefore, the voltage at the collector of the transistor Q7 or node 7 (Fig. 3c) rises quickly to approximately the supply voltage VCC representing the logic level "1". The time T1 is approximately 2 nanoseconds less than the time that will be seen at the corresponding node 7 of Figure 1 during the low-to-high output transition.

During a high-to-low transition (curve C of Fig. 3a), the ECL logic signal at the base of the transistor Q1 of +5 volts is switched to 5 volts minus 750mv representing the logic level "0". Similarly, a low-to-high transition (curve D of Fig. 3b) occurs at the base of the transistor Q2 where the ECL logic signal of +5 volts minus 750 mv is switched to +5 volts representing the logic level "1". This action will render the transistor Q1 to be less conductive and the transistor Q2 will be rendered more conductive. Thus, the potential at the emitter of the transistor Q2 or node 2 will rise toward the +5 volts supply potential so as to create a transient current passing through the diode-connected transistor Q4 and appearing at the node 4. Again, since the capacitors C2 and C4 will act initially as short circuits under transient conditions, a first base drive current will be supplied to the base of the transistor Q7 for turning on the same via the capacitor C2. However, most of the current at the node 6 will pass into the collector of the transistor Q6 since it is turned on, thereby preventing the quick turn on of the transistor Q7. In order to turn on the transistor Q7 faster, it is necessary to turn off the transistor Q6 as quickly as possible. To this end, the transient current at the node 4 is delivered via the capacitor C4 to the base of the transistor Q5 for quickly turning on the same. As a consequence, the base current is rapidly pulled out of the transistor Q6 causing it to turn off quickly. With the transistor Q7 in the conductive state, its collector or node 7 (Fig. 3c) will be quickly pulled down to the collector-emitter drop of the Schottky transistor Q7 or about 0.25 volts representing a logic level "0". The time T2 is approximately 2 nanoseconds less than the time that will be seen at the corresponding node 7 of Figure 1 during the high-to-low output transition.

From the foregoing detailed description, it can thus be seen that the present invention provides an improved logic level translator having high switching speed for converting ECL logic levels into TTL logic levels. This is accomplished by high-pass networks which generate large transient drive current differences at the bases of current mirror transistors so as to facilitate turning them quickly off and on. It should be understood by those skilled in the art that all of the circuit components for the present translator may be formed on a single silicon chip of a semiconductor integrated circuit.

While there has been illustrated and described what is at present to be considered a preferred embodiment of the present invention, it will be understood by those skilled in the art that various changes and modifications may be made, and equivalents may be substituted for elements thereof, without departing from the true scope of the invention. In addition, many modifications may be made to adapt a particular situation or material to the teachings of the invention without departing from the central scope thereof. Therefore, it is intended that this invention not be limited to the particular embodiment disclosed as the best mode contemplated for carrying out this invention, but that the invention will include all embodiments falling within the scope of the appended claims.

-12- 0203700

CLAIMS

1. A logic level translator having high switching speeds for converting ECL logic levels to TTL logic levels, said translator comprising:

a first and second input transistors having their collectors connected to a supply potential, the bases of said first and second transistors being adapted to receive ECL input logic level signals;

a third transistor having its base and collector connected together and to the emitter of said first transistor;

a fourth transistor having its base and collector connected together and to the emitter of said second transistor;

a current mirror formed of a pair of fifth and sixth transistors having their emitters connected together and to a ground potential;

a first resistor and a first capacitor being connected in parallel with its one end connected to the emitter of said third transistor and its other end connected to the collector of said fifth transistor;

a second resistor and a second capacitor being connected in parallel with its one end connected to the emitter of said fourth transistor and its other end connected to the collector of said sixth transistor;

an inverter transistor having its base connected to the collector of said sixth transistor, its collector connected to the supply potential via a load resistor, and its emitter connected to the ground potential;

circuit means for generating large transient drive current differences at the bases of said fifth and sixth transistors so as to facilitate turning on quickly one of said fifth and sixth transistors and turning off quickly the other one of said fifth and sixth transistors; and

said base of said inverter transistor being responsive to said transient drive current differences at the bases of said fifth and sixth transistors so as to create a very fast output response at TTL logic levels on its collector during transitions of the ECL input logic levels.

2. A logic level translator as claimed in Claim 1, wherein said circuit means includes a first high-pass network formed of a third resistor and a third capacitor and a second high-pass network formed of a fourth resistor and a fourth capacitor.

3. A logic level translator as claimed in Claim 2, wherein one end of said fourth resistor is connected to the base of the fifth transistor and one end of the fourth capacitor, the other end of the fourth resistor being connected to one end of the third resistor, the junction of the third and fourth resistors being joined to the collector of the fifth transistor, the other end of the third resistor being connected to the base of the sixth transistor and to one end of the third capacitor, the other end of the third capacitor being connected to the emitter of the third transistor, the other end of the fourth capacitor being connected to the emitter of the fourth transistor.

4. A logic level translator as claimed in Claim 1, wherein said first through sixth transistors are bipolar transistors of the NPN-type.

5. A logic level translator as claimed in Claim 1, wherein said inverter transistor is a Schottky transistor.

6. A logic level translator as claimed in Claim 1, wherein said supply potential is +5.0 volts.

7. A logic level translator as claimed in Claim 1, wherein the ECL-input logic level signals are +5 volts representing the logic level "1" and 5 volts minus 750mv representing the logic level "0".

8. A logic level translator as claimed in Claim 1, wherein the TTL output logic level signals are +5 volts representing the logic level "1" and 0.25 volts representing the logic level "0".

9. A logic level translator as claimed in Claim 1, wherein said translator is formed on a single silicon chip of a semiconductor integrated circuit.

10. A logic level translator having high switching speeds for converting ECL logic levels into TTL logic levels, said translator comprising:

input means for receiving ECL input logic level signals;

output means formed of an output transistor being adapted to provide TTL output logic level signals;

current mirror means interconnected between said input means and said output means for turning on and off said output transistor; and

circuit means for increasing transient response of said current mirror means so as to facilitate turning on and off quickly said output transistor whereby the TTL output logic levels have a relatively small propagation delay in response to transitions of the ECL input logic level signals.

11. A logic level translator as claimed in Claim 10, wherein said transient means includes a first high-pass network formed of a resistor and a capacitor and a second high-pass network formed of a resistor and a capacitor.

12. A logic level translator as claimed in Claim 10, wherein said output transistor comprises a Schottky transistor.

13. A logic level translator as claimed in Claim 10, wherein the ECL input logic signals are +5 volts representing the logic level "1" and 5 volts minus 750mv representing the logic level "0".

14. A logic level translator as claimed in Claim 10, wherein the TTL output logic level signals are +5 volts representing the logic level "1" and 0.25 volts representing the logic level "0".

15. A logic level translator as claimed in Claim 10, wherein said translator is formed on a single silicon chip of a semiconductor integrated circuit.

16. A logic level translator having high switching speeds for converting ECL logic levels to TTL logic levels, said translator comprising:

a first and second input transistors having their collectors connected to a supply potential, the bases of said first and second transistors being adapted to receive ECL input logic level signals:

a current mirror formed of a pair of third and fourth transistors having their emitters connected together and to a ground potential;

a first resistor and a first capacitor being connected in parallel with its one end connected to the emitter of said first transistor and its other end connected to the collector of said third transistor;

a second resistor and a second capacitor being connected in parallel with its one end connected to the emitter of said second transistor and its other end connected to the collector of said fourth transistor;

an inverter transistor having its base connected to the collector of said fourth transistor, its collector connected to the supply potential via a load resistor, and its emitter connected to the ground potential;

circuit means for generating large transient drive current differences at the bases of said third and fourth transistors so as to facilitate turning on quickly one of said third and fourth transistors and turning off quickly the other one of said third and fourth transistors; and

said base of said inverter transistor being responsive to said transient drive current differences at the bases of said third and fourth transistors so as to create a very fast output response at TTL logic levels on its collector during transitions of the ECL input logic levels.

FIG. 1 (PRIOR ART)

0203700

FIG. 2

FIG. 3